Europäisches Patentamt

(19) European Patent Office

Office européen des brevets

(11) **EP 0 650 455 B1**

(12) **EUROPEAN PATENT SPECIFICATION**

(45) Date of publication and mention
of the grant of the patent:
**18.09.1996 Bulletin 1996/38**

(21) Application number: **93916816.7**

(22) Date of filing: **29.06.1993**

(51) Int. Cl.$^6$: **B65G 51/03**, H01L 21/00

(86) International application number:
**PCT/US93/06147**

(87) International publication number:
**WO 94/02395 (03.02.1994 Gazette 1994/04)**

(54) **FLUID TRANSPORT SYSTEM FOR TRANSPORTING ARTICLES**

LUFTKISSENFÖRDERSYSTEM ZUM FÖRDERN VON GEGENSTÄNDEN

SYSTEME DE TRANSPORT FLUIDE POUR LE TRANSPORT D'ARTICLES

(84) Designated Contracting States:
**DE FR GB IT NL**

(30) Priority: **15.07.1992 US 914775**
**22.06.1993 US 78381**

(43) Date of publication of application:
**03.05.1995 Bulletin 1995/18**

(73) Proprietor: **MINNESOTA MINING AND
MANUFACTURING COMPANY
St. Paul, Minnesota 55133-3427 (US)**

(72) Inventors:
(72) Inventors:
• **SKOW, Lynn, R.
Saint Paul, MN 55133-3427 (US)**
• **DUNBAR, William, M.
Saint Paul, MN 55133-3427 (US)**

(74) Representative: **Hilleringmann, Jochen, Dipl.-Ing.
et al
Patentanwälte
von Kreisler-Selting-Werner,
Bahnhofsvorplatz 1 (Deichmannhaus)
50667 Köln (DE)**

(56) References cited:
**DE-B- 1 251 220          FR-A- 2 131 976
GB-A- 2 012 699**

Printed by Rank Xerox (UK) Business Services
2.13.4/3.4

## Description

The present invention relates to a transport system for moving articles. More particularly, the present invention relates to a fluid transport system for moving articles in a controlled manner with the article held adjacent the transport by the conveying fluid, as known from FR-A-2 131 976.

Devices such as air tables which provide a cushion of air on which an article can float are well known. Air conveyers which use air flow to impart translational movement while floating the article along a plane parallel to a surface also are well known.

Transport tables which use directional air jets to transport articles also are known. For example U.S.-A-4,081,201, U.S.-A-4,278,366, and U.S.-A-4,395,165 disclose transporting computer chips and wafers using an air film at low speeds and with the air exiting the system at a large acute angle with respect to the surface along which the chips and wafers are transported. U.S.-A-3,180,688, U.S.-A-3,645,581, U.S.-A-3,614,168 and U.S.-A-3,718,371 disclose various conveyors which use air which exits the system at smaller acute angles less than 30° with respect to the surface along which the articles are transported. U.S.-A-3,231,165 discloses an air conveyor for transporting flexible webs which uses outwardly oriented air outlets. This system requires backwardly facing outlets to help stretch taut the webs as well as a segmented surface to exhaust the transport air. These systems are relatively complex, and simpler and more efficient systems are desired.

None of the known systems mentioned above discloses a fluid transport apparatus which can transport articles including flexible webs in which the working surface, adjacent which articles are transported, is continuous and substantially smooth to permit fluid delivered to the working surface to exhaust off of the working surface at the side edges of the working surface. None of these systems discloses a fluid transport system in which the fluid is delivered to the working surface along first and second arrays which are located on opposite sides of the longitudinal centerline of the working surface to transport flexible articles, with each of the outlets oriented to deliver fluid at an outward angle with the direction of transport to prevent impingement of the fluid flows from the two arrays, without requiring backwardly directed air flow from backwardly directed outlets. None of these systems disclose outlets which can have relatively small length-to-width ratios while ejecting air at small acute angles, and none discloses outlets that create an angular, non-linear, stepped path for the fluid.

From FR-A-2 131 976 a fluid transport system according to the preamble of claim 1 is known. The working surface of this transport system is provided with a plurality of arcuate narrow grooves symmetrically arranged with respect to a center-line, wherein two opposite grooves each form a half-circle-like narrow recess the ends of which are oriented in the transport direction. Air being provided from the centerline of the working surface and fed into the grooves flows out of the top open curved grooves.

It is the object of the present invention to provide a fluid transport system in which the ejection of air is improved so that the article is held to the working surface without contact and with control of the article.

This object is solved in a fluid transport system according to claim 1.

The transport system has a working surface having a longitudinal centerline and two side edges, The working surface is continuous and substantially smooth to permit fluid delivered to the working surface to exhaust off of the working surface at the side edges of the working surface. The article is transported and supported along the working surface by a plurality of orifices terminating in outlets on the working surface. The outlets deliver the fluid to the working surface along first and second arrays which determines the transport path of the article.

The first and second arrays are located on opposite sides of the longitudinal centerline of the working surface and each of the outlets is oriented to deliver fluid at an angle with the direction of transport. The fluid flow direction includes a cross-directional component perpendicular to the direction of transport and a directional component parallel to the direction of transport. The fluid flow from the outlets of the first array does not impinge the fluid flow from the outlets of the second array adjacent the working surface.

The outlets on the working surface extend through the working surface to deliver fluid from the orifices to the working surface at an effective angle (a) wherein each outlet has a cross section on the working surface with a length-to-width ratio $\ell/w$ of each outlet less than that governed by the equation $\ell/w = 1/\sin a$.

The fluid exiting the outlets transports the article along the working surface and supports the article adjacent and spaced from the working surface while preventing the article from contacting the working surface during transport.

The present invention is a transport system for transporting articles which improves upon known transport systems. The transport system transports the article while the article is held to the transport surface without contact and with control of the article. The article can be transported in any orientation.

The invention will be described in more detail referring to the drawings in which

Figure 1A is a schematic perspective view of a transport system of the present invention. Figure 1B is a schematic cross-sectional view of the transport system,

Figure 2 is a cross-sectional view of the transport system of the present invention taken along the array of outlets of Figure 1,

Figure 3 is a partial cutaway top view of the transport system of Figure 1,

Figure 4 is a schematic view of a horizontal one-dimensional, transport path,

Figure 5 is a schematic view of a curved, two-dimensional transport path,

Figure 6 is a schematic view of a helical, three-dimensional transport path,

Figure 7 is a schematic view of an upside-down, horizontal, one-dimensional transport path,

Figure 8 is a schematic view of a downwardly vertical transport path,

Figure 9 is a schematic view of an upwardly vertical transport path,

Figure 10 is a schematic perspective view of an alternative embodiment of the transport system of the present invention,

Figure 11 is a schematic view of the transport system of Figure 10,

Figures 12A and 12B are cross-sectional views of an alternative embodiment of the transport system of the present invention, and

Figure 13 is a schematic cross-sectional view of the transport system showing the transfer of an article from one transport system to another transport system.

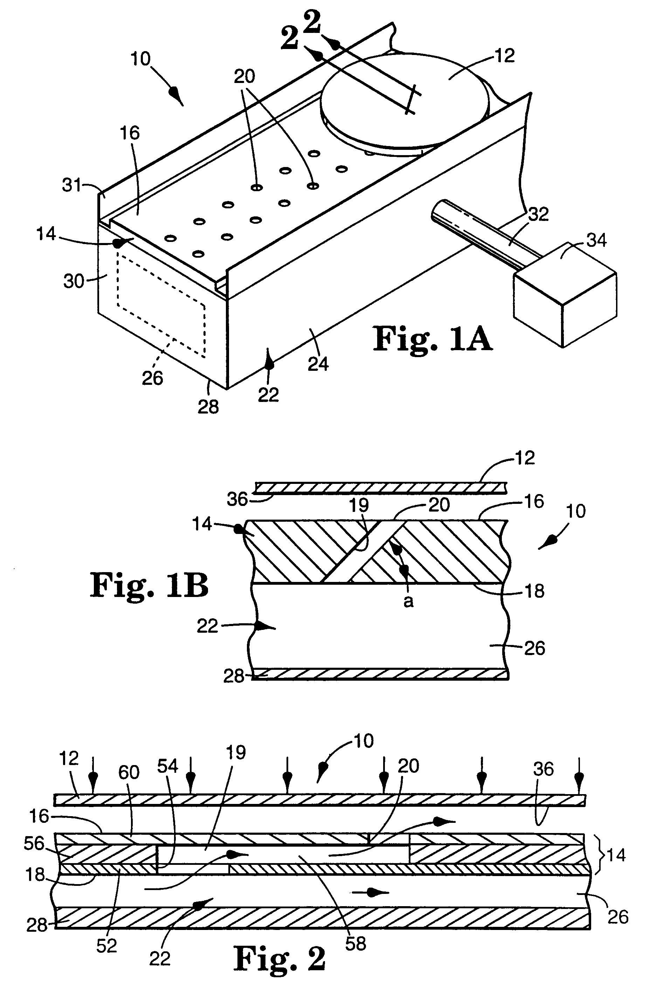

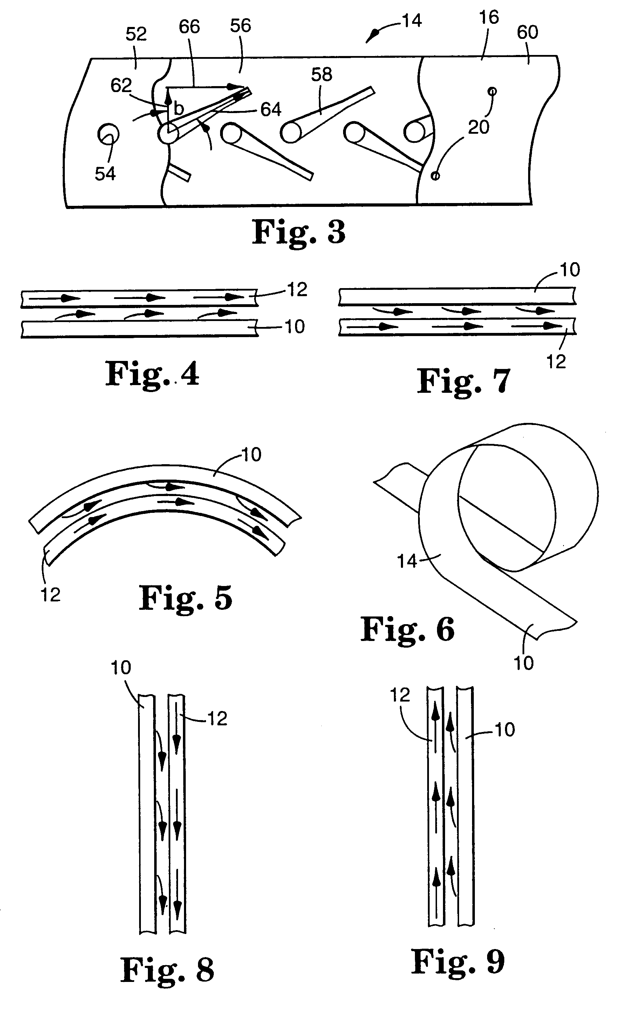

The transport system 10 of the present invention is illustrated in Figures 1-3. The transport system 10 can transport articles 12 without contacting the article. The system 10 can transport articles, including webs such as tape, provided the article has an area-to-weight ratio large enough to be supported via a pressure differential and transported by a given transport system. The transport system 10 can operate with various fluids including air, water, inert fluorocarbons, and various other gases and gas mixtures. The transport system 10 includes a planar element 14, such as a top plate, having a working surface 16 and an opposing surface 18. The articles 12 are transported in a preferred direction as the working surface 16 operates on the articles 12. The working surface 16 may be planar or curved, providing one-dimensional (Figure 4), two-dimensional (Figure 5), or three-dimensional (Figure 6) article paths, depending on the specific application.

As shown in Figure 1A, a plurality of orifices 19 having outlets 20 are in fluid communication with a conduit assembly 22. The orifices 19 serve as an outlet for a conduit assembly. 22, extend through the planar element 14, and are arranged in two arrays of outlets 20 on the working surface 16. As shown, the arrays can be linear. As shown in Figure 1B, which is a generalized schematic illustration of the orifice, each orifice 19 extends through the planar element 14 at an acute angle a, relative to the working surface 16. The outlet 20 of each orifice 19 is also oriented to cause the fluid to exit the outlet 20 at the same angle a with the working surface 16. A pair of outlets 20, each in a respective array of outlets, as shown in Figure 1A, are spaced from each other at a given preferred location. As described below, the location of the arrays of outlets, and the distance between adjacent outlets 20 in an array and adjacent outlets 20 in adjacent arrays can be selected based on the size of the article 12 being transported. The distance, perpendicular to article movement, between adjacent outlets 20 at the same location is selected based on the size of the article 12. For a 3.5 inch magnetic disk, this distance is 1.27 cm (0.5 in). The distance, parallel to article movement, between adjacent outlets 20 in an array of outlets is also selected based on the size of the article 12 and is 1.90 cm (0.75 in) for a 3.5 inch magnetic disk.

The conduit assembly 22, shown in Figure 1A, includes a housing 24 mounted to the opposing surface 18 of the planar element 14. The housing 24 includes a channel which defines a plenum chamber 26 and has a bottom wall 28 and side walls 30, and a top wall formed by the opposing surface 18 of the planar element 14. At least one side wall 30 includes edge guides 31 extending above the working surface 16 to guide the article 12 as it is transported. An inlet 32 extends into the housing 24 and introduces fluid to the plenum chamber 26 for distribution through the orifices 19. The inlet 32 is coupled to a pressurized fluid supply 34 which supplies a fluid to the conduit assembly 22.

The pressurized fluid within the plenum chamber 26 exits through the outlets 20 to deliver a jet-like flow of fluid against the article 12 to provide a motive force to transport the article 12. The jet-like fluid flow creates a pressure differential upon which the article 12 is supported. The pressure differential results in a fixed gap between the working surface 16 of the planar element 14 and a bottom surface 36 of the article 12. The fixed gap is established by balancing and maintaining equilibrium among the forces, including gravity, on the article 12.

The transport characteristics of the article 12 can be altered by changing the angle a as well as the angle b, shown in Figure 3. As the angle b decreases from 90° to 0°, the pressure differential between the top and bottom surfaces of the article 12 is increased and the article velocity decreases. Figures 2 and 3 illustrate a layered construction of a planar element 14.

The layered construction as shown in Figure 3 can be formed of materials that are rigid or flexible and the layers can be laminated to each other. There can be as many layers as are necessary to create the desired outlet configuration within the space constraints of overall thickness and individual layer thickness. Figure 3 illustrates a three layered construction of a planar element 14. The first layer 52 is the inlet or supply layer and includes an opening 54 which serves as the fluid inlet 32. The second layer 56 is a directional layer which includes elongate orifices 58 which are oriented generally in the direction of flow and distribute the fluid in the direction of flow. In this embodiment, these openings 58 define the interior region plenum chamber of the conduit assembly housing. The third layer 60 includes the working surface 16 and outlets 20 of the orifices 19 through which the fluid exits. The opening 54, orifice 58, and outlet 20 combine to form the orifice 19. As is shown in the Figures, each outlet can create an angular, non-linear, stepped path for the fluid.

As shown, the transport system 10 can have a continuous, smooth working surface 16, with no breaks in the surface other than the outlets 20, and with no protrusions, such as edge guides at the side edges. Alternatively, grooves and other minor surface features can be formed in the working surface, but these are not necessary to exhaust fluid. The presence of these surface features makes the working surface substantially smooth. Also, the working surface is at least as long as the articles being transported. The working surface 16 has a longitudinal centerline between the two side edges and need not be segmented to facilitate the exhaust of the fluid. The fluid that is delivered to the working surface exhausts at the side edges of the working surface or at the side edges of the article, depending on whether the article is wider than the working surface.

The first and second arrays of outlets are located on opposite sides of the longitudinal centerline of the working surface 16. Each of the outlets is oriented to deliver fluid at an angle with the direction of transport, as shown in Figure 1A. The directional component 66 of the fluid flow contributes to both the pressure differential and transport of the article 12 while the cross-directional component 62, perpendicular to the directional component 66, contributes only to the pressure differential. The directional and cross-directional components 62, 66 combine to yield the flow direction 64. When the fluid exits with no cross-directional component 62 the system 10 transports articles 12 with less pressure differential than if there were a cross-directional component. When the fluid exits with no directional component 66, the system 10 holds articles 12 with no transport and no contact.

As shown, the direction of the cross-directional component 62 of the fluid flow direction of each outlet 20 in the first array of outlets is away from that of each outlet 20 in the second array of outlets. This orifice orientation permits the system 10 to stretch flexible articles taut, permitting the transport of webs without fluttering or other instability. The perpendicular distance from the first and second arrays of outlets 20 to the respective working surface side edges is selected to assist exhausting of the fluid off of the working surface at the side edge of the working surface. Additionally, the outlets can all be oriented with the directional component of the fluid flow in the direction of article transport. No backwardly-facing outlets are required to stretch taut flexible articles.

Holes may be formed by drilling with a bit having a circular cross section and, when drilling at an acute angle with the plane of the working surface, form an outlet at the working surface having an oval cross section with a length-to-width ratio governed by the drilling angle $\alpha$ as expressed in the equation $\ell/w = 1/\sin \alpha$. However, the outlet area can have any shape, namely for example round, oval, or any regular or irregular polygon as far as its length-to-width ratio $\ell/w$ is less than that governed by the equation

$$\ell/w = \frac{1}{\sin \alpha}.$$

Thus, the outlet 20 can extend through the working surface 16 to deliver fluid to the working surface at an effective angle of less than 20° with an outlet having a length-to-width ratio less than 2.9. The effective angle can be less than 15° and the length-to-width ratio less than 3.8, the effective angle can be less than 10° and the length-to-width ratio less than 5.7, and the effective angle can be less than 5° and the length-to-width ratio less than 11.4.

According to the Bernoulli principle, as the fluid velocity increases, its pressure is reduced from that of the surrounding fluid moving at a lower velocity. The velocity difference causes a pressure difference. An object placed between the high and low velocity fluid will tend to be forced toward the higher velocity fluid until equilibrium is reached. Where a uniform fluid flow is forced between a stationery plate and a movable object, a uniform force will be exerted on the object toward the plate. The object will not contact the plate if the object has an area-to-weight ratio large enough so that the upward force from the fluid jets equals or exceeds the gravitational force and other attractions.

As long as the fluid flow is uniform between the article 12 and the working surface 16 and the article 12 has a sufficiently large area-to-weight ratio, pressure will be exerted on the article toward the working surface. Therefore, the system 10 can operate in any orientation both relative to the web travel direction as well as relative to the cross-web direction. The system 10 can operate when the planar element 14 and the article 12 are horizontal with the article 12 on top of the working surface 16 of the planar element 14 (Figure 4), as well as vertical (Figures 8 and 9), with the article 12 underneath the working surface 16 of the planar element 14 (Figure 7), or at any orientation along the 360° circle of positions. The system 10 is orientation independent.

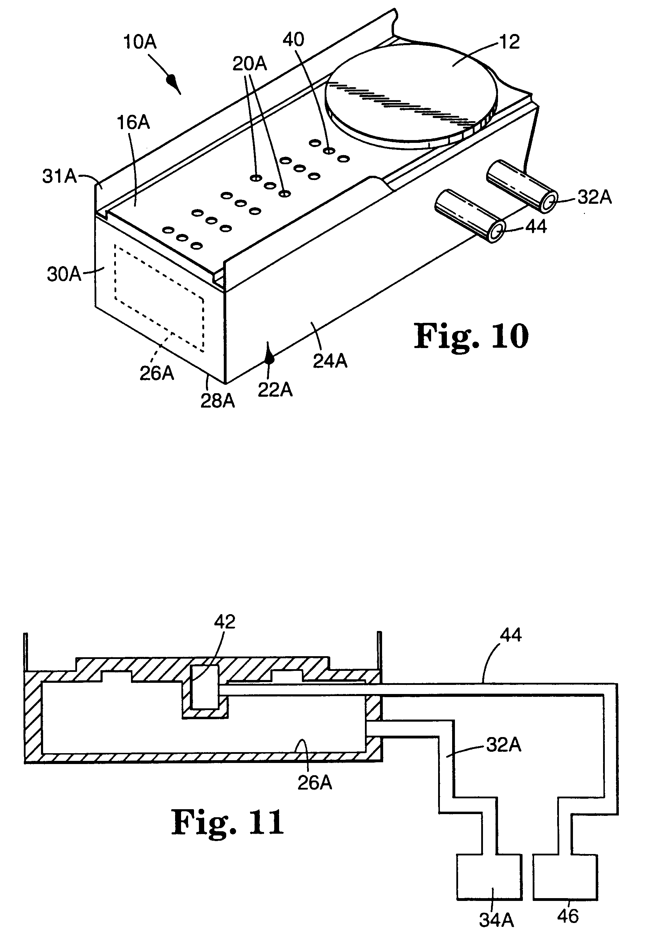

An alternative transport system 10A is shown in Figure 10. The transport system 10A includes a planar element having a working surface 16A. In this embodiment, the planar element is simply a planar surface. The planar element includes first and second arrays of outlets 20A and a third array of outlets 40. All of the outlets 20A, 40 extend through the planar element at an acute angle relative to the working surface 16A. The third array of outlets 40 is directed opposite to the first and second arrays of outlets 20A. The third array of outlets 40 can be centrally located along a central longitudinal axis of the working surface 16A while the first and second arrays of outlets 20A can include two arrays running along each transverse side of the working surface 16A. The distance, parallel to article movement, between adjacent outlets 40 is selected based on the size of the article 12, the flow rate, and the orifice angle, and is 1.90 cm (0.75 in) for a 3.5 inch magnetic disk.

The conduit assembly 22A is in fluid communication with the first and second arrays of outlets 20A, 40. The housing 24A includes a first channel that defines a first plenum chamber 26A positioned beneath the first and second arrays of outlets 20A. A second annular channel of the housing 24A defines a second plenum chamber 42 positioned beneath the third array of outlets 40.

As shown in Figures 10 and 11, first and second inlets 32A, 44, respectively, extend through the housing 24A into the respective first and second plenum chambers 26A, 42. The first and second inlets 32A, 44 are coupled to respective compressed fluid supplies 34A, 46 which supply fluid under pressure to the plenum chambers 26A, 42, which can operate under different pressures. Fluid delivered to the first plenum chamber 26A exits through the first and second arrays of outlets 20A and provides a motive force to transport the article 12. Fluid delivered under pressure to the second plenum chamber 42 exits through the third array of outlets 40 and provides a braking force that counteracts the motive force and thereby controls the speed of transport. This fluid also can provide an increased pressure differential between the article 12 and the surface 16A. Alternatively, the transporting and braking roles of the arrays of outlets can be reversed. As in the previous embodiment, fluid exiting the outlets 20A, 40 supports the article 12 without contact.

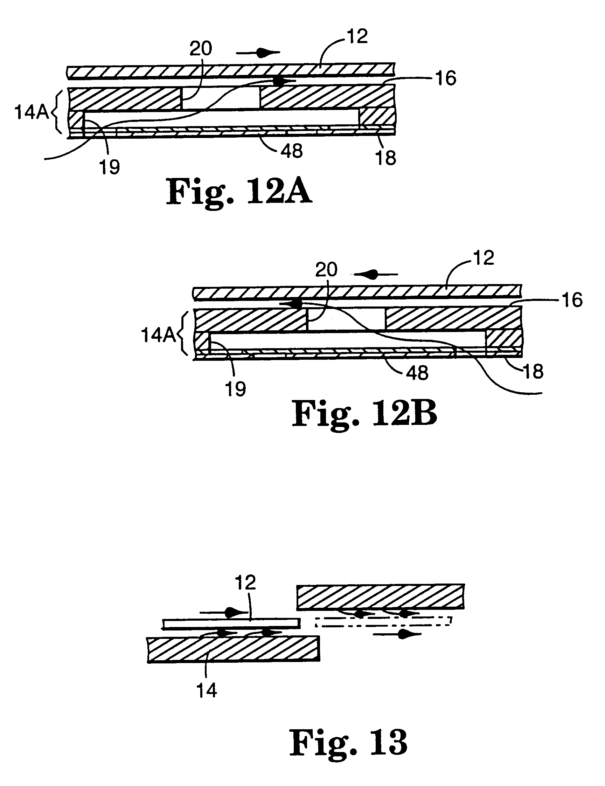

In a modification shown in Figures 12A and 12B, a movable wiper layer 48 can open and close the orifices 19 to turn on and off the fluid jets passing through the orifices. The wiper layer 48 also can reverse the direction of fluid flow through the orifices 19 to change the direction on the article 12. As the wiper layer 48 moves from the position in Figure 12A to that in Figure 12B, the fluid inlet is switched to change the fluid jet direction as shown.

This transport system for articles is relatively uncomplicated and has few moving parts, so partial or complete system failure is less likely. The transported article is highly stable and can be transported at relatively high controlled speeds and with the system 10 upside down or at any other orientation, which can be advantageous.

In this arrangement, articles 12 having the proper area-to-weight ratio will be held to the working surface 16 of the planar element and can be transported in any orientation with excellent speed and directional control. Small outlets 20 expel fluid at high velocity differentials that hold the article 12 to the working surface 16 at a gap of about 0 to about 0.10 cm. An array of outlets 20 in the center of the working surface 16 tends to flatten a web or flexible article that is many times the width spacing of the outlets 20. Also, the fluid jets can control movement in the plane of the working surface 16 and can transfer articles 12 from one planar element to another as shown in Figure 13. Although the planar elements are shown as overlapping, they need not overlap.

In one embodiment, the diameter of the outlets 20, 40 is less than 0.152 cm and the article 12 is transported while being held to the planar element 14 at a distance of about 0 cm to about 0.10 cm to the working surface 16 and the velocity of the fluid ranges from about 100 to about 300 m/s. In another embodiment, an article was transported along a two dimensional circular path at speeds exceeding about 7.6 m/s using less than about 10 watts of power at a spacing with the working surface of less than about 0.015 cm. Depending upon the application, the orifices can be directed at any angle relative to the working surface.

In another example embodiment, the transport system is formed of a layered construction using three layers. (All dimensions are approximate.) The first layer 52 is 0.4 mm thick and is made of a vinyl material with adhesive on one side to adhere to the second layer. The second layer 56 is 0.4 mm thick and also is made of a vinyl material. The second layer can have adhesive on both sides to adhere to the first and third layers. The third layer 60 is 0.1 mm thick and is made of stainless steel. The working surface 16 formed on the third layer 60 is 25 mm wide. This transport system has two arrays of orifices 19 and two arrays of outlets 20 are formed in the working surface 16. The outlets 20 are rectangular and have a width of 1.0 mm and length of 5.0 mm. The outlets are oriented at an angle with respect to a the centerline of the working surface of 30°. The outermost portion of the outlets 20 (from the centerline) is 3.5 mm from the side edge of the working surface, 14.0 mm from corresponding outlets on the other side of the centerline, and 12.0 mm from the outermost portion of the adjacent outlet on the same side of the centerline. The outlet creates an angular, non-linear, stepped path for the fluid. This path causes fluid to exit the outlet at a 1° angle with the working surface. This angle is defined, referring to Figure 2, as the angle formed between the diagonal line connecting the lower left and upper right corners of the outlet 20 formed in the third layer 60 and the working surface 16. (The third layer 60 is 0.1 mm thick and the outlet length is 5 mm.)

A transport system 27 cm long formed in a loop and having 45 outlets was used to transport a flexible tape which was 25.4 cm long, 2.54 cm wide, 25.4 microns thick, and was 0.22 grams. The air mass flow rate entering the inlet in the first layer ranged from 0.0006 kg/sec to 0.0010 kg/sec (the air velocity ranged from 27 m/sec to 235 m/sec with the directional component ranging from 23 m/sec to 204 m/sec). This produced an air velocity at the outlet of up to 300 m/sec transported the article at speeds of up to 1650 cm/sec.

## Claims

1. A transport apparatus for transporting articles (12) comprising:

- a working surface (16;16A) having a longitudinal centerline and two side edges, wherein the working surface (16;16A) is continuous and substantially smooth to permit fluid delivered to the working surface (16;16A) to exhaust off of the working surface (16;16A) at the side edges of the working surface (16;16A), and

- means for orientation independently transporting and supporting the article (12) along the working surface (16;16A) comprising a plurality of orifices (19) terminating in outlets (20,20A) on the working surface (16;16A) for delivering the fluid to the working surface (16;16A) along first and second arrays which determines the transport path of the article (12), wherein the first and second arrays are located on opposite sides of the longitudinal centerline of the working surface (16;16A), wherein each of the orifices (19) is oriented to deliver fluid at an effective angle with the direction of transport, the fluid flow (64) direction including a cross-directional component (62) perpendicular to the direction of transport and a directional component (66) parallel to the direction of transport, and wherein the fluid flow (64) from the outlets (20,20A) of the first array does not impinge the fluid flow from the outlets (20,20A) of the second array adjacent the working surface (16;16A), wherein fluid exiting the outlets (20, 20A) transports the article (12) along the working surface (16;16A) and supports the article (12) adjacent and spaced from the working surface (16;16A) while preventing the article (12) from contacting the working surface (16;16A) during transport, **characterized in that** the outlets (20,20A) extend through the working surface (16;16A) to deliver fluid from the orifices (19) to the working surface (16; 16A) at an effective angle (a) wherein each outlet (20,20A) has a cross section on the working surface (16;16A) with a length-to-width ratio $\ell/w$ of each outlet (20, 20A) less than that governed by the equation $\ell/w = 1/\sin a$ .

2. The transport apparatus according to claim 1 characterized in that each orifice (19) creates an angular, non-linear, stepped path for the fluid.

3. The transport apparatus according to claim 1 characterized in that the working surface (16;16A) is at least as long as the articles (12) being transported.

4. The transport apparatus according to claim 1 characterized in that the direction of the cross-directional component (62) of the fluid flow (64) direction of each outlet (20,20A) in the first array of outlets is away from that of each outlet (20,20A) in the second array of outlets (20,20A) and the directional component (66) of the fluid flow (64) direction of each outlet (20,20A) is in the direction of transport.

5. The transport apparatus according to claim 1 characterized in that the first and second arrays are linear and all of the outlets (20,20A) in each array are longitudinally colinear.

6. The transport apparatus according to claim 1 characterized in that the perpendicular distance from the first and second arrays of outlets (20, 20A) to the respective working surface (16) side edges is selected to assist transporting an article (12) provided as a thin, flexible web without flexing, while maintaining the web in tension.

7. The transport apparatus according to claim 1 characterized by at least one article (12) to be transported and means for delivering a supply of fluid to the orifices (19).

**Patentansprüche**

1. Transportvorrichtung zum Transportieren von Gegenständen (12), mit:

- einer Arbeitsfläche (16;16A) mit einer Längsmittellinie und zwei Seitenrändern, wobei die Arbeitsfläche (16;16A) durchgehend und im wesentlichen glatt ist, um zu ermöglichen, daß der Arbeitsfläche (16;16A) zugeführtes Fluid von der Arbeitsfläche (16,16A) über die Seitenränder der Arbeitsfläche (16;16A) entweichen kann, und

- einer Einrichtung zum richtungsunabhängigen Transportieren und Halten des Gegenstandes (12) entlang der Arbeitsfläche (16;16A), wobei die Einrichtung eine Vielzahl von Öffnungen (19) aufweist, welche in Auslässen (20,20A) in der Arbeitsfläche (16;16A) zum Zuführen von Fluid zu der Arbeitsfläche (16;16A) entlang einer ersten und einer zweiten Auslaßanordnung enden, und den Transportweg des Gegenstandes (12) bestimmt, wobei die erste und die zweite Auslaßanordnung zu entgegengesetzten Seiten der Längsmittellinie der Arbeitsfläche (16;16A) angeordnet sind, wobei die Öffnungen (19) jeweils so ausgerichtet sind, daß sie Fluid unter einem effektiven Winkel zur Transportrichtung zuführen, wobei die Fluidströmung (64) eine senkrecht zur Transportrichtung verlaufende Querrichtungskomponente (62) und eine parallel zur Transportrichtung verlaufende Richtungskomponente (66) aufweist, und wobei die Fluidströmung (64) aus den Auslässen (20,20A) der ersten Auslaßanordnung im arbeitsflächennahen Bereich nicht auf die Fluidströmung aus den Auslässen (20,20A) der zweiten Auslaßanordnung auftrifft, wobei das aus den Auslässen (20,20A) austretende Fluid den Gegenstand (12) die Arbeitsfläche (16;16A) entlang transportiert und den Gegenstand (12) im arbeitsflächennahen Bereich beabstandet von der Arbeitsfläche (16;16A) hält, wobei verhindert wird, daß der Gegenstand (12) während des Transports die Arbeitsfläche (16;16A) kontaktiert,

**dadurch gekennzeichnet, daß**

die Auslässe (20,20A) zum Zuführen von Fluid aus den Öffnungen (19) zu der Arbeitsfläche (16;16A) unter einem effektiven Winkel (a) durch die Arbeitsfläche (16;16A) verlaufen, wobei jeder Auslaß (20,20A) an der Arbeitsfläche (16;16A) einen Querschnitt aufweist, wobei das Verhältnis von Länge zu Breite $\ell/w$ jedes Auslasses (20,20A) geringer als das von der Gleichung $\ell/w = 1/\sin a$ bestimmte Verhältnis ist.

2. Transportvorrichtung nach Anspruch 1, dadurch gekennzeichnet, daß jede Öffnung (19) einen winkligen, nicht-linearen, gestuften Weg für das Fluid bildet.

3. Transportvorrichtung nach Anspruch 1, dadurch gekennzeichnet, daß die Arbeitsfläche (16;16A) mindestens so lang wie die transportierten Gegenstände (12) ist.

4. Transportvorrichtung nach Anspruch 1, dadurch gekennzeichnet, daß die Querkomponente (62) der Richtung der Fluidströmung (64) jedes Auslasses (20,20A) in der ersten Auslaßanordnung von derjenigen jedes Auslasses (20,20A) in der zweiten Anordnung von Auslässen (20,20A) weggerichtet ist und die Längskomponente (66) der Richtung der Fluidströmung (64) jedes Auslasses (20,20A) in Transportrichtung weist.

5. Transportvorrichtung nach Anspruch 1, dadurch gekennzeichnet, daß die erste und die zweite Auslaßanordnung linear sind und alle Auslässe (20,20A) in jeder Auslaßanordnung in Längsrichtung kollinear sind.

6. Transportvorrichtung nach Anspruch 1, dadurch gekennzeichnet, daß der Abstand von der ersten und der zweiten Anordnung der Auslässe (20,20A) zu den jeweiligen Seitenrändern der Arbeitsfläche (16) so gewählt ist, daß er den Transport eines als dünne flexible Bahn vorgesehenen Gegenstandes (12) ohne Biegen unterstützt, wobei die Bahn gespannt gehalten wird.

7. Transportvorrichtung nach Anspruch 1, gekennzeichnet durch mindestens einen zu transportierenden Gegenstand (12) und eine Einrichtung zum Zuführen einer Fluidmenge zu den Öffnungen (19).

## Revendications

1. Dispositif de transport pour le transport d'articles (12) comprenant :

   - une surface de travail (16;16A) possédant un axe central longitudinal et deux bords latéraux, la surface de travail (16;16A) étant continue et essentiellement uniforme de manière à permettre à un fluide envoyé à la surface de travail (16;16A) de sortir de cette surface de travail (16;16A) au niveau des bords latéraux de la surface de travail (16;16A), et
   - des moyens pour transporter et supporter l'article (12), d'une manière indépendante de l'orientation, le long de la surface de travail (16;16A), comprenant une pluralité d'orifices (19) se terminant par des sorties (20,20A) dans la surface de travail (16;16A) pour délivrer le fluide à la surface de travail (16;16A) au niveau de premier et second réseaux qui déterminent le trajet de transport de l'article (12), les premier et second réseaux étant situés sur des côtés opposés de l'axe central longitudinal de la surface de travail (16;16A), chacun des orifices (19) étant orienté de manière à délivrer le fluide sous un angle effectif par rapport à la direction de transport, la direction de l'écoulement de fluide (64) incluant une composante (62) s'étendant dans la direction transversale et perpendiculaire à la direction de transport et une composante directionnelle (66) parallèle à la direction de transport, et l'écoulement de fluide (64) délivré par les sorties (20,20A) du premier réseau ne rencontrant pas l'écoulement de fluide délivré par les sorties (20,20A) du second réseau au voisinage de la surface de travail (16;16A), le fluide sortant par les sorties (20,20A) transportant l'article (12) le long de la surface de travail (16;16A) et supportant l'article (12) dans une position voisine et espacée de la surface de travail (16;16A) tout en empêchant l'article (12) de venir en contact avec la surface de travail (16;16A) pendant le transport,

   caractérisé en ce que

   les sorties (20,20A) traversent la surface de travail (16;16A) pour délivrer le fluide provenant des orifices (10) à la surface de travail (16;16A) sous un angle effectif (a), chaque sortie (20,20A) possédant une section transversale, dans la surface de travail (16;16A), avec un rapport longueur / largeur l/w de chaque sortie (20,20A) inférieur à celui fixé par la relation l/w = 1/sin a .

2. Dispositif de transport selon la revendication 1, caractérisé en ce que chaque orifice (19) crée un trajet angulaire, non linéaire et, étagé pour le fluide.

3. Dispositif de transport selon la revendication 1, caractérisé en ce que la surface de travail (16;16A) est au moins aussi longue que les articles transportés (12).

4. Dispositif de transport selon la revendication 1, caractérisé en ce que la direction de la composante (62), qui s'étend dans la direction transversale, de la direction de l'écoulement de fluide (64) de chaque sortie (20,20A) du premier réseau de sorties est opposée à celle de chaque sortie (2O,2OA) du second réseau de sorties (2O, 2OA) et la composante directionnelle (66) de la direction de l'écoulement de fluide (64) de chaque sortie (20,2OA) s'étend dans la direction de transport.

5. Dispositif de transport selon la revendication 1, caractérisé en ce que les premier et second réseaux sont linéaires et toutes les sorties (20,20A) de chaque réseau sont colinéaires longitudinalement.

6. Dispositif de transport selon la revendication 1, caractérisé en ce que la distance perpendiculaire des premier et second réseaux de sorties (20,20A) par rapport aux bords latéraux respectifs de la surface de travail (16) est choisie de manière à faciliter le transport d'un article (12) sous la forme d'une bande mince flexible, sans flexion, tout en maintenant la bande en traction.

7. Dispositif de transport selon la revendication 1, caractérisé par au moins un article (12) devant être transporté et des moyens pour envoyer une alimentation de fluide aux orifices (19).

**Fig. 1A**

**Fig. 1B**

**Fig. 2**

**Fig. 3**

**Fig. 4**

**Fig. 7**

**Fig. 5**

**Fig. 6**

**Fig. 8**

**Fig. 9**

**Fig. 10**

**Fig. 11**

**Fig. 12A**

**Fig. 12B**

**Fig. 13**